# EUROPÄISCHE PATENTSCHRIFT

(11) **EP 1 331 982 B1**
(45) Veröffentlichungstag und Bekanntmachung des Hinweises auf die Patenterteilung: **26.04.2006**
(21) Anmeldenummer: 01976295.4
(22) Anmeldetag: 10.10.2001
(51) Int. Cl.: B01D 46/42, H05K 7/20, F24F 13/28

(54) **HAUBE FÜR EINEN FILTERLÜFTER**
HOOD FOR A FILTER FAN
CALOTTE POUR AERATEUR DE FILTRE

(30) Priorität: 18.10.2000 DE 10051643
(43) Veröffentlichungstag der Anmeldung: 06.08.2003
(73) Patentinhaber: STEGO-Holding GmbH, 74523 Schwäbisch Hall (DE)
(72) Erfinder: GUILLIARD, Dietmar, 74535 Mainhardt-Gailsbach (DE)
(74) Vertreter: Bohnenberger, Johannes
(86) Internationale Anmeldenummer: PCT/EP2001/011727
(87) Internationale Veröffentlichungsnummer: WO 2002/032547

(56) Entgegenhaltungen:
- EP-A- 0 453 657
- DE-A- 9 010 394
- DE-A- 19 700 065
- DE-U- 9 306 032
- US-A- 5 120 919
- US-A- 5 213 596
- US-A- 5 769 916
- PATENT ABSTRACTS OF JAPAN vol. 1997, no. 06, 30. Juni 1997 (1997-06-30) & JP 09 036577 A (FUJITSU LTD), 7. Februar 1997 (1997-02-07)

## Beschreibung

Die Erfindung betrifft eine Haube für einen Filterlüfter gemäß dem Oberbegriff des Anspruches 1.

Filterlüfter der in Rede stehenden Art sind aus dem Stand der Technik bekannt und werden vornehmlich zur Belüftung von Schaltschrankinnenräumen, Schaltungsgehäusen, Gerätegehäusen oder dergleichen verwendet. Um die im jeweiligen Innenraum entstehende Wärme elektronischer Steuereinrichtungen und Schaltungen abzuführen, wird über einen Filterlüfter kalte Frischluft zugeführt, welche durch eine an einer Außenwand des zu belüftenden Raumes angebrachte Haube geführt wird, durch einen in einer Durchbrechung der Außenwand liegenden Filter tritt, und schließlich über ein hinter diesem Filter liegendes Gebläse in den zu belüftenden Raum abgegeben wird. Der Filter nimmt dabei die Funktion der Staubabscheidung in der zugeführten Kaltluft gegenüber den im Innenraum liegenden elektronischen Baugruppen wahr. Insbesondere elektronische Schaltungen im Umfeld von Produktions- und/oder Kraftwerksanlagen werden dadurch vor schneller Verschmutzung durch Staub und der damit verbundenen Gefahr von Ausfällen durch Kurzschlüsse, vor allem in feuchten Umgebungen, geschützt. Beim Einsatz von Filterlüftern in stark verschmutzten Umgebungen ist deshalb ein regelmäßiger Austausch der Filter zur Sicherstellung einer garantierten Kühlleistung unumgänglich.

Die Montage eines Filterlüfters der in Rede stehenden Art setzt üblicherweise die Zugänglichkeit des zu belüftenden Raumes von innen und außen voraus. So wird das innenliegende Gebläse zusammen mit dem Filter von der Innenseite des zu belüftenden Raumes in die Durchbrechung der Außenwand gesteckt und dann von der Außenseite des Raumes kommend mit der Wand verbunden, während die außenliegende und darüber angeordnete Haube wiederum von der Innenseite des Raumes kommend montiert wird. Diese Art der Anbringung lässt aber den Wechsel des zwischen Gebläse und Haube sitzenden Filters nur unter entsprechend aufwändiger Demontage zumindest der Haube des Filterlüfters zu. Montageaktivitäten im Innenraum eines Schaltschrankes, Schaltungsgehäuses, Gerätegehäuses oder dergleichen erfordern aus Sicherheitsgründen zudem die Abschaltung der betroffenen Elektronik und verursachen entsprechende Ausfallzeiten der gesteuerten Maschinen und Anlagen. Ein regelmäßig notwendiger Filterwechsel eines Filterlüfters ist deshalb aufwändig und kostenintensiv.

Aus der DE-U-930 60 32, der US-A-5 769 916 und der DE-U-90 10 394 sind jeweils Filterlüfter bekannt, bei welchen vor dem Filter ein Abdeckgitter sitzt. Zum Austauschen des Filters wird das Abdeckgitter entfernt. Dies ist besonders dann aufwändig, wenn das Abdeckgitter in korrekter Weise vibrationsfest angebracht sein muss.

Es ist Aufgabe der vorliegenden Erfindung, eine Haube für einen Filterlüfter anzugeben, welche durch entsprechende konstruktive Gestaltung ein müheloses und schnelles Wechseln des Filters ermöglicht.

Diese Aufgabe wird durch eine Haube eines Filterlüfters nach Patentanspruch 1 gelöst.

Ein wesentlicher Punkt der vorliegenden Erfindung ist dabei, den Zugang zum Filter von der Außenseite des zu belüftenden Raumes ohne eine zeitweise Stillegung der Elektronik im Innenraum zu gewährleisten. Dies wird durch eine von außen zugängliche Wartungsöffnung erreicht, die durch mindestens eine schwenkbare Klappe verschließbar ist. Dabei kann die Wartungsöffnung sowohl durch Verschwenken der gesamten Haube wie auch durch Öffnung einer mit der Haube schwenkbar verbundenen Klappe freigegeben werden. Es ist weiterhin denkbar, die gesamte Haube wie auch eine mit dieser Haube verbundene Klappe so zu unterteilen, daß eine flügelartige Öffnung der Hauben- oder Klappensegmente zu zwei oder mehr Seiten vorgenommen werden kann und damit eine optimale Zugänglichkeit des Filters ermöglicht wird. Schlecht zugängliche Filterlüfter könnten alternativ statt mit einer Klappe auch mit einem rolladenartigen Verschluß der Wartungsöffnung ausgestattet werden. Vorteilhafterweise bietet aber gerade eine schwenkbar gelagerte Haube oder eine mit der Haube schwenkbar verbundene Klappenkonstruktion nicht nur optimalen Zugriff auf den Filter, sondern auch gleichzeitig eine ungestörte Luftzuführung von der Lufteintrittsöffnung zum Filter durch keine bzw. sehr geringe Einschnürungen des Luftkanals aufgrund des Verbaus von Lagern oder Verschlüssen in diesem Bereich.

Vorteilhafterweise wird die Haube eines Filterlüfters mit einer Klappe versehen, die Halterelemente aufweist, welche den Filter beim Schließen der Klappe in der vorgesehenen Position und beim Öffnen der Klappe freigeben. Da der Filter im Regelfall eine mattenartige Struktur aufweist, wird er nach dem Einsetzen in die vorgesehene Öffnung, insbesondere in vertikaler Lage, durch geeignete Maßnahmen in dieser Position gehalten werden müssen. Vorzugsweise geschieht dies bei der vorliegenden Erfindung durch mit der Klappe verbundene Halterelemente, die den Filter nach dem Schließen der Klappe in seine Aufnahmeöffnung drücken und somit am Verrutschen hindern. Beim Öffnen der Klappe wiederum werden die Halterelemente vom Filter weggeschwenkt und dieser damit zum Wechseln freigegeben.

Besonders bevorzugterweise wird die Haube eines Filterlüfters mit einer Klappe versehen, deren Halterelemente eine bügelartige Form aufweisen. Diese bügelartige Form läßt eine über die Länge des Bügels gleichmäßige Flächenpressung auf den Filter zu, wodurch dieser sicher in seiner gewünschten Form und Position in der Öffnung zum Innenraum gehalten wird. Gleichzeitig ist die Formgebung und Anbringung eines solchen Bügels mit geringem konstruktivem Aufwand möglich. Durch seinen geringen Querschnitt stellt ein solcher Bügel zudem praktisch kein Hindernis in dem Luftkanal zwischen Lufteintrittsöffnung und Filter dar, wodurch die Kühlleistung des Filterlüfters auch nicht beeinträchtigt wird.

Eine besonders einfache konstruktive Lösung zur Fixierung des Filters in der vorgesehenen Position ergibt sich dann, wenn die Halterelemente fest mit der Klappe verbunden sind. Beim Öffnen der Klappe wird dann der Filter komplett freigegeben und kann gewechselt werden, beim Schließen der Klappe wird der neue Filter in seiner Position fixiert.

Vorteilhafterweise können aber auch die Halterelemente elastisch federnd mit der Klappe verbunden sein. Dadurch wird beim Öffnen der Klappe der Filter durch Verschwenken der Halterelemente nicht komplett freigegeben, sondern von den elastisch federnd mit der Klappe verbundenen Halterelementen weiterhin in seiner Position fixiert, dies jedoch mit geringerem Anpressdruck der Halterelemente als bei geschlossener Klappe. Dadurch kann der Filter in diesem Moment nicht aus der vorgesehenen Position verrutschen und möglicherweise in das Innere der Haube fallen. Erst nach händischem Wegdrücken oder -Ziehen der elastisch federnd gelagerten Halterelemente ist dann ein Wechsel des Filters möglich. Umgekehrt wird dann schon vor dem Schließen der Klappe der neue Filter in seiner Position gehalten, bevor die Klappe ganz geschlossen ist. Durch derart elastisch federnd mit der Klappe verbundene Halterelemente kann sichergestellt werden, daß nach dem vollständigen Schließen der Klappe der Filter genau in der Position fixiert ist in der er eingelegt wurde. Erst bei geschlossener Klappe wird dann der gewünschte Anpressdruck der Halterelemente auf den Filter erreicht. Durch eine derartige Variation des Anpressdruckes, abhängig vom Öffnungswinkel der Klappe, wird der Filterwechsel besonders leicht handhabbar. Trotz dieser offensichtlichen Vorteile ist es der Einfachheit halber natürlich auch denkbar, elastisch federnde Halterelemente nicht mit der Klappe, sondern an einer anderen Stelle an der Innenseite der Haube eines Filterlüfters oder an ihm selbst anzubringen.

Zur Sicherstellung der einwandfreien Funktion eines Filterlüfters, d.h. der garantierten Zufuhr von Kaltluft von außen zur Kühlung von elektronischen Baugruppen im zu belüftenden Raum, ist vorzugsweise die Klappe mit der Haube verriegelbar. Dadurch wird sichergestellt, daß insbesondere in Produktionsumgebungen die Klappe nicht durch Stöße oder Vibrationen aus ihrer geschlossenen Position gebracht werden kann.

In öffentlichen Gebäuden wird vorteilhafterweise die Klappe mit der Haube über ein Schloß verriegelbar ausgestaltet sein. Dadurch wird nur dem Wartungspersonal die Möglichkeit gegeben, Eingriffe am Filterlüfter vorzunehmen.

In Umgebungen, die der Öffentlichkeit nicht zugänglich sind, kann vorteilhafterweise die Klappe mit der Haube auch über mindestens einen magnetischen Anschlag in geschlossener Position gehalten werden. Dies erleichtert zum einen den Zugriff auf den Filter und bietet zum anderen eine einfachere und kostengünstigere Verschlußvariante.

Bevorzugterweise wird die Klappe auf einer Oberseite mit einem Griff und/oder einem Eingriff zur leichten Öffnung versehen. Ein solcher Griff und/oder Eingriff erleichtert die Handhabung der Klappe bei Wartungsarbeiten erheblich.

Vorteilhafterweise kann die Klappe in einer im wesentlichen rechteckigen Form konstruktiv ausgeführt werden. Eine solche Form bietet den Vorteil einer entsprechend groß zu gestaltenden Wartungsöffnung bei einer gleichzeitig einfachen Lagerung der Klappe an einer der Längsseiten. Spielt dagegen in öffentlichen Gebäuden oder Steuerzentralen größerer Betriebe die Einpassung in ein bestimmtes Gesamtdesign eine Rolle, ist natürlich auch denkbar, von der im wesentlichen rechteckigen Form der Klappe, möglicherweise auch unter Einbußen der Funktionalität, zugunsten einer anderen z.B. einer dreieckigen Form abzuweichen.

Zum weitgehend luftdichten Verschluß der Wartungsöffnung weisen Vorteilhafterweise die Klappe und/oder die Wartungsöffnung an ihren Rändern Dichtelemente auf. Dadurch wird insbesondere sichergestellt, daß von außen angesaugte Kaltluft nur durch die Lufteintrittsöffnung der Haube in das Innere des zu lüftenden Raumes geführt wird. Ist die Lufteintrittsöffnung der Haube in einen bevorzugten Ansaugbereich ausgerichtet, wird über die Klappe der Wartungsöffnung auch keine möglicherweise wärmere Luft herangeführt. Dies kann insbesondere dann entscheidend sein, wenn die Haube des Filterlüfters mit nach unten zeigender Lufteintrittsöffnung in Deckennähe an der Außenwand des zu belüftenden Raumes angebracht ist.

Vorzugsweise werden die Dichtelemente einer Haube eines Filterlüfters aus einer Nut- und Federverbindung bestehen. Die solchermaßen ineinandergreifenden Bauteile sorgen, z.B. auch in Verbindung mit einer eingelegten Gummidichtung, für eine einfache und sichere Abdichtung (auch hinsichtlich EMV) der Wartungsöffnung gegen die Klappe.

Weitere Ausführungsformen der Erfindung ergeben sich aus den Unteransprüchen.

Nachfolgend wird die Erfindung anhand eines Ausführungsbeispieles beschrieben, welches anhand der Abbildungen näher erläutert wird. Hierbei zeugen:
Figur 1 eine geschnittene Seitenansicht durch eine Haube (10) eines Filterlüfters mit geöffneter Klappe (30); und
Figur 2 eine geschnittene Seitenansicht durch die Haube (10) des Filterlüfters aus Figur 1 mit geschlossener Klappe (30).

Für gleiche oder gleich wirkende Teile werden im folgenden gleiche Bezugsziffern verwendet, welche in den Figuren aus Gründen der Übersichtlichkeit nicht alle dargestellt werden.

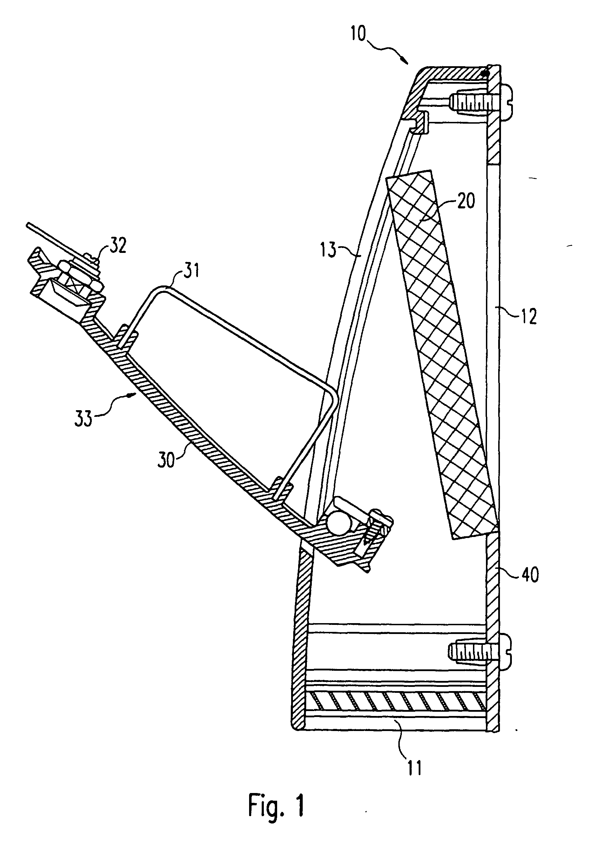

Figur 1 zeigt eine geschnittene Seitenansicht einer Haube (10) eines Filterlüfters mit geöffneter Klappe (30), welche in dieser Stellung die Wartungsöffnung (13) zum Wechseln des Filters (20) - hier in halb aus der Luftaustrittsöffnung (12) ausgebauten Position gezeichnet - freigibt. Die Haube (10) selbst ist an der Außenwand (40) eines Schaltschrankes, Schaltungsgehäuses, Gerätegehäuses oder dergleichen vom Innenraum kommend verschraubt und verfügt über eine Lufteintrittsöffnung (11), über welche die zur Kühlung vorgesehene Kaltluft vom Außenraum angesaugt wird, entlang des Innenprofils der Haube (10) streicht und schließlich durch den Filter (20) tritt, hinter dem im Regelfall ein im zu belüftenden Raum befindliches Gebläse (hier nicht gezeigt) angeordnet ist. In der Oberseite (33) der Klappe (30) kann optional ein Griff und/oder Eingriff angebracht sein, welcher aber aufgrund des hier vorgesehenen Schlosses (32), welches mit einem Schlüssel bedient werden kann, entfällt. Die Halterelemente 31 - von denen hier aufgrund der geschnittenen Seitenansicht nur eines zu erkennen ist, werden beim Öffnen der Klappe 30 zum Filter 20 weggeschwenkt und geben damit den Filter 20 zum Wechseln frei. Damit ist ein einfacher Zugriff auf den Filter 20 von der Außenseite des zu belüftenden Raumes unter gleichzeitiger Gewährleistung einer sicheren Fixierung des Filters 20 in der gewünschten Position möglich.

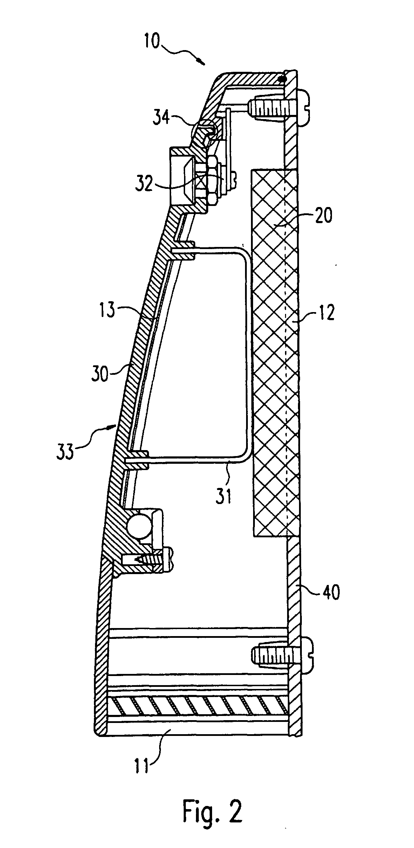

Figur 2 zeigt eine geschnittene Seitenansicht der Haube 10 des Filterlüfters aus Figur 1 mit nunmehr geschlossener Klappe 30, wobei nun der Filter 20 mittels der bügelartigen Halterelemente 31 - sicher in die Luftaustrittsöffnung 12 der Haube 10 zum zu belüftenden Raum gedrückt wird. Durch Verriegelung der Klappe 30 mit der Haube 10 über das Schloß 32 wird die Klappe 30 in der gewünschten Verschlußposition gehalten und kann auch nur durch das Wartungspersonal mittels Schlüssel geöffnet werden. In dieser Position der Klappe 30 werden die aus einer Nut- und Federverbindung bestehenden Dichtelemente 34 ineinander eingerückt und gewährleisten damit einen luftdichten Verschluß der Wartungsöffnung.

Das in den Figuren 1 und 2 gezeigte Vorgehen zum Wechseln des Filters 20 der Haube 10 eines Filterlüfters demonstriert die Vorzüge der vorliegenden Erfindung auf zweierlei Weise. Zum einen ist es nunmehr möglich, von der Außenseite des zu belüftenden Raumes ohne Aufwand und längere Abschaltzeiten der Elektronik über eine schwenkbare Klappe 30 einen Wechsel des Filters 20 vorzunehmen, zum anderen sind durch die Anbringung von Halterelementen 31 - Maßnahmen vorgesehen, die den Filter 20 nach Schließen der Klappe 30 sicher in der vorgesehenen Position fixieren. Entsprechende Dichtelemente 34 sorgen dabei gleichzeitig für einen luftdichten Verschluß der Wartungsöffnung 13 zur Sicherstellung des Kaltlufteintritts durch die Lufteintrittsöffnung 11.

An dieser Stelle sei darauf hingewiesen, daß alle oben beschriebenen Teile für sich alleine gesehen und in jeder Kombination, insbesondere die in den Zeichnungen dargestellten Details als erfindungswesentlich beansprucht werden. Abänderungen hiervon sind dem Fachmann geläufig.

### Bezugszeichenliste

- 10: Haube
- 11: Lufteintrittsöffnung
- 12: Luftaustrittsöffnung
- 13: Wartungsöffnung
- 20: Filter
- 30: Klappe
- 31: Halterelemente
- 32: Schloß
- 33: Oberseite
- 34: Dichtelemente
- 40: Außenwand

## Patentansprüche

1. Haube für einen Filterlüfter, welche mit einer Außenwand eines Schaltschrankes, eines Schaltungsgehäuses oder eines Gerätegehäuses verbindbar ist und Folgendes aufweist:
- eine Lufteintrittsöffnung (11);
- eine Luftaustrittsöffnung (12);
- einen zwischen der Lufteintrittsöffnung (11) und der Luftaustrittsöffnung (12) angebrachten Filter (20);
**dadurch gekennzeichnet, dass**
zusätzlich zur Lufteintrittsöffnung (11)
- eine Wartungsöffnung (13), insbesondere zum Wechseln des Filters (20) vorgesehen ist und
- die Wartungsöffnung (13) durch mindestens eine vorzugsweise schwenkbare Klappe (30) luftdicht verschließbar ist.

2. Haube für einen Filterlüfter nach Anspruch 1,
**dadurch gekennzeichnet, daß**
die Klappe (30) mit der Haube schwenkbar verbunden ist.

3. Haube für einen Filterlüfter nach einem der Ansprüche,
**dadurch gekennzeichnet , daß**
die Klappe (30) Halterelemente (31) aufweist, welche den Filter (20) beim Schließen der Klappe (30) in der vorgesehenen Position fixieren und beim öffnen der Klappe (30) zum Wechseln freigeben.

4. Haube für einen Filterlüfter nach einem der vorhergehenden Ansprüche, insbesondere Anspruch 3,
**dadurch gekennzeichnet , daß**
die Halterelemente (31) eine bügelartige Form aufweisen.

5. Haube für einen Filterlüfter nach einem der vorhergehenden Ansprüche, insbesondere Anspruch 3 und 4,
**dadurch gekennzeichnet , daß**
die Halterelemente (31) fest mit der Klappe (30) verbunden sind.

6. Haube für einen Filterlüfter nach einem der vorhergehenden Ansprüche, insbesondere Anspruch 3 und 4,
**dadurch gekennzeichnet , daß**
die Halterelemente (31) elastisch federnd mit der Klappe (30) verbunden sind.

7. Haube für einen Filterlüfter nach einem der vorhergehenden Ansprüche,
**dadurch gekennzeichnet, daß**
die Klappe (30) mit der Haube verriegelbar ist.

8. Haube für einen Filterlüfter nach einem der vorhergehenden Ansprüche, insbesondere nach Anspruch 7
**dadurch gekennzeichnet , daß**
die Klappe (30) mit der Haube über ein Schloß (32) verriegelbar ist.

9. Haube für einen Filterlüfter nach einem der vorhergehenden Ansprüche,
**dadurch gekennzeichnet, daß**
die Klappe (30) mit der Haube über mindestens einen magnetischen Anschlag in geschlossener Position gehalten wird.

10. Haube für einen Filterlüfter nach einem der vorhergehenden Ansprüche,
**dadurch gekennzeichnet , daß**
die Klappe (30) auf einer Oberseite (33) mit einem Griff und/oder Eingriff zur leichten Öffnung versehen ist.

11. Haube für einen Filterlüfter nach einem der vorhergehenden Ansprüche,
**dadurch gekennzeichnet, daß**
die Klappe (30) eine im wesentlichen rechteckige Form aufweist.

12. Haube für einen Filterlüfter nach einem der vorhergehenden Ansprüche,
**dadurch gekennzeichnet, daß**
die Klappe (30) und/oder die Wartungsöffnung (13) an ihren Rändern Dichtelemente (34) zum weitgehend luftdichten Verschluß der Wartungsöffnung aufweist.

13. Haube für einen Filterlüfter nach einem der vorhergehenden Ansprüche, insbesondere Anspruch 12,
**dadurch gekennzeichnet, daß**
die Dichtelemente (34) aus einer Nut- und Federverbindung bestehen.

## Claims

1. A hood for a filter fan, which can be connected to an outer wall of a switchgear cabinet, a circuit housing or an appliance housing, and has the following:
- an air inlet opening (11);
- an air outlet opening (12);
- a filter (20) mounted between the air inlet opening (11) and the air outlet opening (12);
**characterised in that**
in addition to the air inlet opening (11)
- a maintenance opening (13) is provided, in particular for changing the filter (20), and
- the maintenance opening (13) can be closed airtightly by at least one preferably pivotable flap (30) .

2. A hood for a filter fan according to Claim 1, **characterised in that** the flap (30) is pivotably connected to the hood.

3. A hood for a filter fan according to one of the preceding Claims, **characterised in that** the flap (30) has retaining elements (31) which secure the filter (20) in the intended position when the flap (30) is closed and when the flap (30) is opened release it so that it can be changed.

4. A hood for a filter fan according to any one of the preceding Claims, in particular Claim 3, **characterised in that** the retaining elements (31) are of clip-like form.

5. A hood for a filter fan according to any one of the preceding Claims, in particular Claims 3 and 4, **characterised in that** the retaining elements (31) are securely connected to the flap (30) .

6. A hood for a filter fan according to any one of the preceding Claims, in particular Claims 3 and 4, **characterised in that** the retaining elements (31) are connected to the flap (30) in an resiliently flexible manner.

7. A hood for a filter fan according to any one of the preceding Claims, **characterised in that** the flap (30) can be locked to the hood.

8. A hood for a filter fan according to any one of the preceding Claims, in particular Claim 7, **characterised in that** the flap (30) can be locked to the hood via a lock (32).

9. A hood for a filter fan according to any one of the preceding Claims, **characterised in that** the flap (30) is retained with the hood in the closed position via at least one magnetic stop member.

10. A hood for a filter fan according to any one of the preceding Claims, **characterised in that** on its upper side (33) the flap (30) is provided with a handle and/or catch for ease of opening.

11. A hood for a filter fan according to any one of the preceding Claims, **characterised in that** the flap (30) is of substantially rectangular shape.

12. A hood for a filter fan according to any one of the preceding Claims, **characterised in that** on its edges the flap (30) and/or the maintenance opening (13) has sealing elements (34) for the substantially air-tight closure of the maintenance opening.

13. A hood for a filter fan according to any one of the preceding Claims, in particular Claim 12, **characterised in that** the sealing elements (34) comprise a groove and tongue joint.

## Revendications

1. Capot pour un aérateur à filtre, susceptible d'être relié à une paroi extérieure d'une armoire de commande, d'un boîtier à circuits ou d'un boîtier d'appareil, et comprenant :
- une ouverture d'entrée d'air (11) ;
- une ouverture de sortie d'air (12) ;
- un filtre (20) agencé entre l'ouverture d'entrée d'air (11) et l'ouverture de sortie d'air (12) ;
**caractérisé en ce que**
il est prévu en supplément à l'ouverture d'entrée d'air (11)
- une ouverture d'entretien (13), en particulier pour changer de filtre (20), et
- l'ouverture d'entretien (13) est susceptible d'être refermée de façon étanche à l'air par au moins un clapet (30) de préférence pivotant.

2. Capot pour un aérateur de filtre selon la revendication 1,
**caractérisé en ce que**
le clapet (30) est relié au capot avec faculté de pivotement.

3. Capot pour un aérateur de filtre selon l'une des revendications précédentes,
**caractérisé en ce que**
le clapet (30) comprend des éléments de maintien (31) qui fixent le filtre (20) dans la position prévue lors de la fermeture du clapet (30) et qui le libère pour l'échange lors de l'ouverture du clapet (30).

4. Capot pour un aérateur de filtre selon l'une des revendications précédentes, en particulier selon la revendication 3,
**caractérisé en ce que**
les éléments de maintien (31) présentent une forme d'arceau.

5. Capot pour un aérateur de filtre selon l'une des revendications précédentes, en particulier selon les revendications 3 et 4,
**caractérisé en ce que**
les éléments de maintien (31) sont reliés solidairement au clapet (30).

6. Capot pour un aérateur de filtre selon l'une des revendications précédentes, en particulier selon les revendications 3 et 4,
**caractérisé en ce que**
les éléments de maintien (31) sont reliés au clapet (30) avec effet ressort élastique.

7. Capot pour un aérateur de filtre selon l'une des revendications précédentes,
**caractérisé en ce que**
le clapet (30) est susceptible d'être verrouillé avec le capot.

8. Capot pour un aérateur de filtre selon l'une des revendications précédentes, en particulier selon la revendication 7,
**caractérisé en ce que**
le clapet (30) est susceptible d'être verrouillé avec le capot par un verrou (32).

9. Capot pour un aérateur de filtre selon l'une des revendications précédentes,
**caractérisé en ce que**
le clapet (30) est maintenu en position fermée avec le capot par au moins une butée magnétique.

10. Capot pour un aérateur de filtre selon l'une des revendications précédentes,
**caractérisé en ce que**
sur un côté supérieur (33) le clapet (30) est pourvu d'une poignée et/ou d'un moyen de préhension pour faciliter l'ouverture.

11. Capot pour un aérateur de filtre selon l'une des revendications précédentes,
**caractérisé en ce que**
le clapet (30) présente une forme sensiblement rectangulaire.

12. Capot pour un aérateur de filtre selon l'une des revendications précédentes,
**caractérisé en ce que**
le clapet (30) et/ou l'ouverture d'entretien (13) présente à ses bords des éléments d'étanchéité (34) pour l'obturation largement étanche à l'air de l'ouverture d'entretien.

13. Capot pour un aérateur de filtre selon l'une des revendications précédentes, en particulier selon la revendication 12,
**caractérisé en ce que**
les éléments d'étanchéité (34) sont constitués par une liaison à languette et rainure.
